# EUROPÄISCHE PATENTSCHRIFT

(11) **EP 2 664 936 B1**
(45) Veröffentlichungstag und Bekanntmachung des Hinweises auf die Patenterteilung: **22.08.2018**
(21) Anmeldenummer: 13170882.8
(22) Anmeldetag: 10.05.2012
(51) Int. Cl.: G01R 31/327, G01R 27/20, G01R 31/333

(54) **Messvorrichtung zum Überprüfen eines elektrischen Leistungsschalters**
Measuring device for testing an electrical circuit breaker
Dispositif de mesure destiné à contrôler un disjoncteur électrique

(43) Veröffentlichungstag der Anmeldung: 20.11.2013
(62) Teilanmeldung aus: 12003725.4
(73) Patentinhaber: Omicron electronics GmbH, 6833 Klaus (AT)
(72) Erfinder: Klapper, Ulrich, 6830 Rankweil (AT)
(74) Vertreter: Banzer, Hans-Jörg

(56) Entgegenhaltungen:
- EP-A1- 2 163 911
- WO-A1-2009/131530
- APOSTOLOV A ET AL: "Testing requirements for IEC 61850 based devices", POWER SYSTEMS CONFERENCE: ADVANCED METERING, PROTECTION, CONTROL, COMMUNICATION, AND DISTRIBUTED RESOURCES, 2007. PSC 2007, IEEE, PISCATAWAY, NJ, USA, 13. März 2007 (2007-03-13), Seiten 249-253, XP031403300, ISBN: 978-1-4244-0854-2
- EDSEL ATIENZA: "Testing and troubleshooting IEC 61850 GOOSE-based control and protection schemes", PROTECTIVE RELAY ENGINEERS, 2010 63RD ANNUAL CONFERENCE FOR, IEEE, PISCATAWAY, NJ, USA, 29. März 2010 (2010-03-29), Seiten 1-7, XP031679124, ISBN: 978-1-4244-6073-1

## Beschreibung

Die vorliegende Erfindung betrifft Messvorrichtungen zum Überprüfen eines elektrischen Leistungsschalters, insbesondere zum Überprüfen von elektrischen Leistungsschaltern in elektrischen Energieerzeugungs- und -übertragungsanlagen nach einer Inbetriebnahme oder Revision des Leistungsschalters.

Leistungsschalter, welche auch als Hochspannungsschalter oder Circuit Breaker bezeichnet werden, sind spezielle Schalter, welche für hohe Ströme ausgelegt sind. In energietechnischen Anlagen, wie z.B. Energieerzeugungsanlagen wie Kraftwerken oder Energieübertragungsanlagen, schalten Leistungsschalter nicht nur Betriebsströme, sondern bei Fehlern auch hohe Überlastströme oder Kurzschlussströme. Leistungsschalter können sowohl zum Einschalten dieser Ströme als auch zum Ausschalten der Ströme verwendet werden. Ein Leistungsschalter umfasst üblicherweise einen Schaltkontakt und einen Steuerantrieb, welcher den Schaltkontakt mechanisch antreibt. Der Steuerantrieb kann beispielsweise Federantriebe oder Druckluftantriebe umfassen, welche mechanische Energie speichern, welche zum schnellen Schalten des Schaltkontakts verwendet wird. Die Feder- oder Druckluftantriebe können beispielsweise mit elektrischen Antrieben vorgespannt oder "aufgeladen" werden. Das Freigeben der gespeicherten mechanischen Energie zum Schalten des Schaltkontakts kann über sogenannte Auslösespulen, welche elektrisch angesteuert werden, erfolgen. In den elektrischen Anlagen gibt es üblicherweise eine Stationsbatterie die eine Gleichspannung (DC Spannung) zwischen 48 und 200V zur Verfügung stellt, um die Auslösespulen mit Energie zu versorgen. Zum Öffnen oder Schließen wird dann lediglich noch ein potentialfreier Relaiskontakt benötigt. Im Betrieb kommen die Kommandos zum Öffnen oder Schließen üblicherweise von Schutzrelais oder der Leittechnik.

In diesem Zusammenhang offenbart die WO 2009/131530 A1 eine Messvorrichtung zum Messen des Widerstandes von Hochspannungsvorrichtungen. Die Messvorrichtung umfasst eine Stromquelle, welche mit einem Testobjekt verbindbar ist, und Mittel zum Messen. Die Stromquelle ist ein Kondensator, wodurch eine leichtgewichtige Vorrichtung erhalten werden kann, welche im Wesentlichen durchgängig ohne Nichtverwendungszeiten für ein Wiederaufladen verwendet werden kann. Bei einer Ausführungsform wird eine Stromquelle über einen Schalter und einen Messwiderstand mit Ausgängen verbunden, welche mit dem Testobjekt verbunden werden. Zusammen mit einem Messverstärker stellen der Schalter und der Messwiderstand ein Signal proportional zu dem Strom durch das Testobjekt bereit. Der Schalter wird mittels eines Auslösesignals angesteuert, um eine gewünschte Betriebsart bereitzustellen, welche beispielsweise eine Strompulslänge steuert.

Bei einer Überprüfung eines elektrischen Leistungsschalters wird üblicherweise ein sogenannter Mikroohm-Test durchgeführt, bei welchem bei geschlossenem Schaltkontakt der am Leistungsschalter auftretende Widerstand mittels einer Einspeisung eines vorbestimmten Stroms gemessen wird. Der vorbestimmte Strom kann mehrere hundert Ampere betragen, beispielsweise 200 A. Weiterhin kann beim Überprüfen des elektrischen Leistungsschalters ein sogenannter Timing-Test durchgeführt werden, bei welchem eine Schaltdauer erfasst wird, welche der Schalter benötigt, um nach Anlegen eines Steuerbefehls den Schaltbefehl auszuführen. Weiterhin kann ein sogenannter Verlustfaktor- oder Tangens-Delta-Test durchgeführt werden, wenn sich der Leistungsschalter in einem geerdeten Gehäuse befindet, einem so genannten Tank. Der Verlustfaktor-Test wird auch als "Dead Tank Test" bezeichnet.

Zur Durchführung des Timing-Tests müssen Steuerbefehle abgesetzt werden, um den Schalter zu öffnen und zu schließen. Die Auslösespulen brauchen dazu eine gewisse Energie. Gemäß dem Stand der Technik kommt diese Energie entweder von der Stationsbatterie oder von einem weiteren Gerät, das während der Prüfung die benötigte DC Spannung zur Verfügung stellt. Es werden auch Tests durchgeführt, bei dem die DC Spannung unter den nominalen Wert verringert wird, um zu überprüfen ob der Schalter auch bei verminderter Spannung einwandfrei arbeitet. Dieser Test wird auch als Unterspannungstest bezeichnet. Diese benötigte Energiequelle wird im folgenden als Energieversorgungseinheit bezeichnet. Die Energieversorgungseinheit kann auch dazu verwendet werden, den Energiespeicher im Steuerantrieb des Schalters nachzuladen. Dies erfolgt über anlegen einer Wechselspannung (AC Spannung) oder DC Spannung üblicherweise im Bereich von 48V DC bis 230V AC nominal.

Zur Durchführung der zuvor beschriebenen Tests werden üblicherweise verschiedene Geräte verwendet, welche der Reihe nach mit dem Leistungsschalter zur Durchführung der entsprechenden Tests verbunden werden, wobei die Energieversorgungseinheit bei einigen Tests auch gleichzeitig verwendet werden kann.

Aufgabe der vorliegenden Erfindung ist es daher, eine Messvorrichtung bereitzustellen, mit welcher ein elektrischer Leistungsschalter zuverlässig und effizienter als in dem Stand der Technik überprüft werden kann. Diese Aufgabe wird gemäß der vorliegenden Erfindung durch eine Messvorrichtung zum Überprüfen eines elektrischen Leistungsschalters nach Anspruch 1 gelöst. Die abhängigen Ansprüche definieren bevorzugte und vorteilhafte Ausführungsformen der Erfindung.

Gemäß der vorliegenden Erfindung wird eine Messvorrichtung zum Überprüfen eines elektrischen Leistungsschalters bereitgestellt, welche eine Stromerzeugungseinheit, eine Messeinheit, einen Steuerausgang und eine Steuereinheit mit einem Zeitgeber umfasst. Die Stromerzeugungseinheit ist zur Erzeugung eines Messstroms für eine Durchgangsmessung eines Schaltkontakts des Leistungsschalters ausgestaltet und mit dem Leistungsschalter koppelbar, um den Messstrom in den Leistungsschalter einzuspeisen. Die Messeinheit ist mit dem Leistungsschalter koppelbar und in der Lage, ein Messsignal, beispielsweise einen Spannungsabfall über dem Schaltkontakt des Leistungsschalters, an dem Leistungsschalter zu erfassen. Über den Steuerausgang können Signale zum Öffnen und/oder Schließen des Leistungsschalters ausgegeben werden. Dazu kann der Steuerausgang mit einem Steuerantrieb des Leistungsschalters gekoppelt werden. Die Steuereinheit ist in der Lage, über den Steuerausgang ein Signal zum Öffnen oder Schließen des Leistungsschalters auszugeben und mittels des Zeitgebers ein zeitliches Schaltverhalten des Leistungsschalters in Abhängigkeit von dem Messsignal zu bestimmen. Das Signal, welches die Steuereinheit über den Steuerausgang zum Öffnen oder Schließen des Leistungsschalters ausgibt, umfasst eine Steuernachricht gemäß der Norm IEC 61850. Die Norm IEC 61850 beschreibt Busse und Protokolle, welche in energietechnischen Anlagen, wie z.B. Umspannwerken, verwendet werden, um Kommandos, beispielsweise sogenannte Goose-Nachrichten, zu übertragen oder Daten oder Datenströme zu transportieren (IEC 61850-9-2). Goose-Kommandos können beispielsweise verwendet werden, um Befehle zum Öffnen oder Schließen von Leistungsschaltern zu übertragen. Somit ist die Messvorrichtung in der Lage, beim Test oder beim Überprüfen eines Leistungsschalters diese Kommandos zum Öffnen oder Schließen des Leistungsschalters selbst zu erzeugen, so dass keine zusätzlichen Komponenten zum Test des Leistungsschalters benötigt werden.

Die Durchgangsmessung bezeichnet im Rahmen dieser Beschreibung eine Messung, welche zumindest anzeigt, ob der Schaltkontakt des Leistungsschalters durchgeschaltet ist oder nicht. Dies kann beispielsweise bestimmt werden, indem mittels der Messeinheit ein Spannungsabfall über dem Schaltkontakt bestimmt wird. Wenn der Spannungsabfall einen vorbestimmten Wert unterschreitet, wird bestimmt, dass der Schaltkontakt durchgeschaltet ist. Anderenfalls wird bestimmt, dass der Schaltkontakt geöffnet ist. Alternativ kann auch der durch den Leistungsschalter fließende Messstrom bestimmt werden und der Schaltkontakt als geschlossen bestimmt werden, sobald eine vorbestimmte Stromgröße überschritten wird. Alternativ dazu kann auch versucht werden, einen Strom über den Kontakt zu treiben. Ist dies möglich ist der Schalter geschlossen, wenn nicht ist der Schalter geöffnet. Die Messeinheit ist mit dem Leistungsschalter koppelbar und in der Lage, ein Messsignal an dem Leistungsschalter zu erfassen. Das Messsignal kann insbesondere einen Spannungsabfall über dem Schaltkontakt des Leistungsschalters umfassen.

Gemäß einer Ausführungsform umfasst die Vorrichtung ferner eine Energieversorgungseinheit. Die Energieversorgungseinheit ist ausgestaltet, einen Steuerantrieb des Leistungsschalters mit elektrischer Energie zu versorgen, welcher den Schaltkontakt des Leistungsschalters wahlweise öffnet oder schließt. Wie zuvor bereits beschrieben wurde, kann der Steuerantrieb des Leistungsschalters einen Energiespeicher zum Betätigen des Schaltkontakts umfassen, wie z.B. einen Federantrieb oder einen Gasantrieb. Der Steuerantrieb kann ferner einen Motor zum Spannen der Feder oder Komprimieren des Gases, d.h. zum "Aufladen" des Energiespeichers, umfassen. Die Energieversorgungseinheit versorgt daher beispielsweise diesen Motor mit elektrischer Energie. Der Steuerantrieb des Leistungsschalters kann alternativ auch beispielsweise einen Kondensator umfassen, welcher elektrische Energie speichert, um ausreichend Energie zum elektromechanischen Öffnen oder Schließen des Schaltkontakts des Leistungsschalters bereitzustellen. In diesem Fall ist die Energieversorgungseinheit in der Lage, diesen Kondensator mit elektrischer Energie zu versorgen.

Der Steuerausgang ist mit dem Steuerantrieb des Leistungsschalters koppelbar und ausgestaltet, Signale zum Öffnen und/oder Schließen des Leistungsschalters auszugeben. Der Leistungsschalter kann beispielsweise Auslöseelemente oder Auslösespulen aufweisen, welche mit einer Gleichspannung von beispielsweise 200 V angesteuert werden, um das Öffnen oder Schließen des Schaltkontakts des Leistungsschalters einzuleiten. Der Steuerantrieb wird über ein Kommando oder eine Steuernachricht gemäß der Norm IEC 61850 zum Öffnen oder Schließen des Leistungsschalters angesteuert. Der Steuerausgang stellt entsprechende Steuernachrichten gemäß IEC 61850 bereit. Dadurch kann die Messvorrichtung den Leistungsschalter ohne zusätzliche Komponenten direkt ansteuern, wodurch die Durchführung der Überprüfung des Leistungsschalters vereinfacht werden kann.

Die Steuereinheit umfasst einen Zeitgeber, um zeitliche Abläufe genau protokollieren zu können. Die Steuereinheit ist ausgestaltet, über den Steuerausgang ein Signal zum Öffnen oder Schließen des Leistungsschalters auszugeben und ein zeitliches Schaltverhalten des Leistungsschalters in Abhängigkeit von dem Messsignal zu bestimmen. Beispielsweise kann die Steuereinheit mittels des Zeitgebers die Zeit messen, welche zwischen dem Ausgeben des Signals zum Öffnen oder Schließen des Leistungsschalters und dem tatsächlichen Öffnen bzw. Schließen des Leistungsschalters vergeht. Bei geschlossenem Leistungsschalter ist die Steuereinheit ferner in der Lage, den Widerstand des Schaltkontakts in Abhängigkeit von dem Messstrom und dem Messsignal zu bestimmen.

Die Messvorrichtung kann ein Gehäuse in Form einer tragbaren Einheit umfassen, in welchem zumindest die Stromerzeugungseinheit, die Messeinheit, die Energieversorgungseinheit, der Steuerausgang und die Steuereinheit untergebracht sind. Dadurch kann mit einer Messvorrichtung sowohl ein Timing-Test als auch ein Mikroohm-Test des Leistungsschalters durchgeführt werden. Dabei werden Komponenten, wie z.B. die Stromerzeugungseinheit und die Messeinheit gemeinsam verwendet, wodurch Kosten für die Messvorrichtung eingespart werden können. Darüber hinaus können, nachdem die Messvorrichtung an den Leistungsschalter angeschlossen ist, beide Messungen oder Tests durchgeführt werden, ohne dass eine Neuverkabelung erforderlich ist. Dadurch kann die Überprüfung des elektrischen Leistungsschalters effizienter durchgeführt werden. Indem die Messvorrichtung zusätzlich die Energieversorgungseinheit für den Steuerantrieb umfasst, kann der Test des Leistungsschalters unabhängig davon durchgeführt werden, ob vor Ort eine entsprechende Energieversorgungseinheit für den Steuerantrieb des Leistungsschalters vorhanden ist oder nicht. Falls vor Ort eine entsprechende Energieversorgung vorhanden ist, beispielsweise eine Stationsbatterie oder ein entsprechender Stromanschluss, kann diese Energieversorgung genutzt und somit ebenfalls auf Ihre Funktionsfähigkeit hin überprüft werden.

Wie zuvor beschrieben, kann der Leistungsschalter einen Motor zum Spannen einer Feder oder zum Komprimieren eines Gases oder einen aufladbaren Kondensator umfassen. Dadurch kann ein Energiespeicher gebildet werden, welcher die eigentliche Energie zur Betätigung des Schaltkontakts liefert. Über beispielsweise Auslösespulen wird beim eigentlichen Schalten ein Befehl an den Schalter zum Schalten abgesetzt und die Energie des Energiespeichers dazu verwendet, den Schaltkontakt zu betätigen. Danach wird der Energiespeicher wieder nachgeladen. Gemäß einer Ausführungsform stellt die Energieversorgungseinheit die Energie für den Energiespeicher bereit. Weiterhin kann die Messvorrichtung ausgestaltet sein, eine elektrische Leistung zum Steuern der Auslösevorrichtungen über den Steuerausgang bereitzustellen, wodurch den Auslösevorrichtungen des Steuerantriebs des Leistungsschalters Signale zum Öffnen und/oder Schließen des Leistungsschalters zugeführt werden können. Indem die Messvorrichtung die Energie zum Laden des Energiespeichers des Steuerantriebs des Leistungsschalters und zum Ansteuern der Auslösevorrichtungen bereitstellt, kann der Leistungsschalter ohne zusätzliche Energieversorgungssysteme mittels der Messvorrichtung betrieben und überprüft werden.

Gemäß einer Ausführungsform ist die Messeinheit ausgestaltet, einen Messsignalverlauf zu erfassen. In Abhängigkeit von dem Messstrom und dem Messsignalverlauf ist die Steuereinheit in der Lage, einen Widerstandsverlauf des Schaltkontakts beispielsweise während eines Schließ- oder Öffnungsvorgangs zu bestimmen. Somit kann nicht nur der Übergangswiderstand des Schaltkontakts im geschlossenen Zustand, sondern auch eine Änderung des Widerstands des Schaltkontakts während des Öffnens oder Schließens des Schaltkontakts bestimmt und überprüft werden. Anhand dieser Informationen kann beispielsweise ein Verschleißzustand und eine ordnungsgemäße Funktionsfähigkeit des Schaltkontakts überprüft werden.

Bei einer weiteren Ausführungsform umfasst die Messvorrichtung eine Hochspannungserzeugungseinheit, welche zur Erzeugung einer Hochspannung für eine Verlustfaktormessung ausgestaltet ist. Weiterhin kann die Messvorrichtung eine Verlustfaktormessvorrichtung umfassen, welcher ausgestaltet ist, einen Verlustfaktor des Leistungsschalters in Abhängigkeit von der Hochspannung zu bestimmen. Die Verlustfaktormessvorrichtung kann beispielsweise eine Verlustfaktormessbrücke umfassen, mit welcher die Hochspannung, beispielsweise bis zu 12 kV, an einen Testanschluss einer kapazitiven Durchführung eines geerdeten Gehäuses, in welchem der Leistungsschalter angeordnet ist, zugeführt wird. Die Verlustfaktormessvorrichtung überprüft beispielsweise inwieweit die Kapazität der kapazitiven Durchführung von einer idealen oder geforderten Kapazität abweicht. Eine derartige Abweichung wird auch als Power Factor, Dissipation Factor oder Tangens-Delta bezeichnet. Diese Information ist zur Beurteilung des Zustands der Durchführung nützlich. Leistungsschalter in einem geerdeten Gehäuse werden auch als Dead Tank Circuit Breakers bezeichnet. Durch die Kombination der Leistungsschalterprüfung mit der Verlustfaktormessung kann eine Gesamteinheit aus Leistungsschalter und geerdetem Gehäuse auf einfache Art und Weise und effizient überprüft werden.

Insbesondere kann die Messvorrichtung ein Gehäuse in Form einer tragbaren Einheit umfassen, in dem Stromerzeugungseinheit, Messeinheit, Energieversorgungseinheit und Steuerausgang und untergebracht sind. Die Energieversorgungseinheit kann weiters auch zur Versorgung der Hochspannungserzeugungseinheit und Verlustfaktormesseinrichtung verwendet werden. Dadurch können Leistungsschalter, welche in einem geerdeten Gehäuse untergebracht sind, mit nur einem Messsystem überprüft werden. Darüber hinaus können durch die Verwendung der Stromerzeugungseinheit zur Versorgung des Schalters während der Prüfung und zur Versorgung der Hochspannungserzeugungseinheit in einem gemeinsamen Gehäuse Komponenten, wie z.B. ein Schaltnetzteil aber vor allem auch ein Leistungsverstärker, gemeinsam verwendet werden, wodurch die Kosten und das Gewicht und Volumen der Messvorrichtung verringert werden können.

Gemäß einer Ausführungsform ist die Steuereinheit ferner ausgestaltet, ein Signal von einem Hilfskontakt des Leistungsschalters zu empfangen. Das Signal von dem Hilfskontakt zeigt einen Fortschritt des Öffnens oder Schließens des Leistungsschalters an. In Abhängigkeit von dem Messsignal und dem Signal von dem Hilfskontakt ist die Steuereinheit in der Lage, das zeitliche Schaltverhalten des Leistungsschalters zu bestimmen. Das Signal von dem Hilfskontakt des Leistungsschalters kann mittels einer Nachricht gemäß der Norm IEC 61850 von dem Leistungsschalter zu der Steuereinheit übertragen werden oder von der Steuereinheit von dem Leistungsschalter abgefragt werden. Mittels der Informationen über den Schaltfortschritt kann das zeitliche Schaltverhalten des Leistungsschalters detailliert erfasst und überprüft werden.

Obwohl die in der obigen Zusammenfassung beschriebenen speziellen Merkmale in Verbindung mit speziellen Ausführungsformen beschrieben wurden, ist es klar, dass die Merkmale der beschriebenen Ausführungsformen beliebig miteinander kombiniert werden können.

Die vorliegende Erfindung wird nachfolgend unter Bezugnahme auf die Zeichnung im Detail erläutert werden.
Fig. 1 zeigt eine Messvorrichtung gemäß einer Ausführungsform der vorliegenden Erfindung in Verbindung mit einem Leistungsschalter.
Fig. 2 zeigt eine weitere Ausführungsform einer Messvorrichtung gemäß der vorliegenden Erfindung.

In der nachfolgenden Beschreibung verschiedener Ausführungsformen können direkte Verbindungen oder Kopplungen zwischen funktionalen Blöcken, Vorrichtungen, Komponenten oder physikalischen oder funktionalen Einheiten, welche in den Figuren gezeigt sind oder hierin beschrieben sind, auch mittels einer indirekten Verbindung oder Kopplung realisiert werden. Gleiche Bezugszeichen in den verschiedenen Figuren bezeichnen ähnliche oder identische Komponenten. Weiterhin ist es klar, dass die Merkmale der verschiedenen hierin beschriebenen exemplarischen Ausführungsformen beliebig miteinander kombiniert werden können.

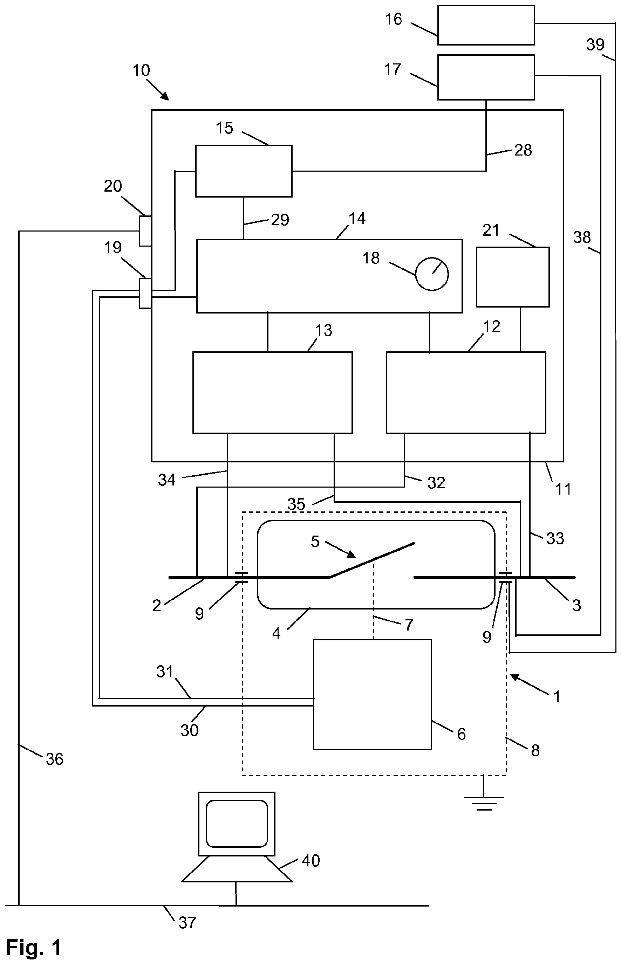

Fig. 1 zeigt einen Leistungsschalter 1, eine Messvorrichtung 10 und eine Auswertevorrichtung 40, ein so genanntes Hauptgerät oder eine sogenannte Bodenstation. Der Leistungsschalter 1 umfasst einen Schaltkontakt 5, welcher eine elektrische Verbindung zwischen zwei Leitungen 2, 3, beispielsweise Hochspannungsleitungen, wahlweise herstellt oder trennt. Der Schaltkontakt 5 ist in einem Gehäuse 4 angeordnet. Der Leistungsschalter 1 umfasst weiterhin einen Steuerantrieb 6, welcher den Schaltkontakt 5 über eine mechanische Kopplung 7 mechanisch ansteuert. Der Steuerantrieb 6 kann mechanische oder elektrische Energiespeicher umfassen, welche über Auslöseelemente angesteuert werden können, um die mechanische Energie zum Öffnen oder Schließen des Schaltkontakts 5 über die mechanische Kopplung 7 bereitzustellen. Der Energiespeicher des Steuerantriebs 6 kann beispielsweise Federn umfassen, welche mittels eines Elektromotors vorgespannt werden können und über Auslösespulen derart ausgelöst werden können, dass sie beim Entspannen mechanische Energie über die mechanische Kopplung 7 an den Schaltkontakt 5 übertragen. Alternativ kann der Energiespeicher einen Gasantrieb umfassen, in welchem Gas komprimiert wird und über einen Auslösemechanismus expandiert werden kann. Durch die Expansion des Gases kann der mechanische Antrieb 7 zur Ansteuerung des Schaltkontakts 5 angetrieben werden. Weiterhin kann der Steuerantrieb 6 einen elektrischen Energiespeicher umfassen, welcher mit einer vorbestimmten Energiemenge aufgeladen wird, um diese Energiemenge in einem kurzen Zeitraum über einen elektromechanischen Wandler zur Ansteuerung des Schaltkontakts 5 abzugeben. Zum Aufladen des Energiespeichers des Steuerantriebs 6 wird dem Steuerantrieb 6 über eine Leitung 30 elektrische Energie zur Verfügung gestellt, beispielsweise bei einer Wechselspannung von 230 V. Zum Ansteuern der Auslöseelemente des Steuerantriebs 6, d.h. zum Ansteuern eines Vorgangs zum Öffnen oder Schließen des Schaltkontakts 5, wird dem Steuerantrieb 6 ein Steuersignal von einer Steuereinheit 14 der Messvorrichtung 10 über eine Leitung 31 zugeführt. Die Steuereinheit 14 bezieht die notwendige Energie aus einer Energieversorgungseinheit 15 der Messvorrichtung 10 über eine Leitung 29. Das Steuersignal kann beispielsweise ein Gleichspannungssignal mit beispielsweise einer Spannung von 200 V sein, wodurch die Auslöseelemente des Steuerantriebs 6 ausgelöst werden können. Alternativ kann die Leitung 31 eine digitale Datenbusverbindung umfassen, über welche das Steuersignal zum Auslösen der Auslöseelemente des Steuerantriebs 6 in Form von digitalen Telegrammen, so genannten Goose-Kommandos, gemäß beispielsweise der Norm IEC 61850 übertragen wird.

Der Schaltkontakt 5 des Leistungsschalters 1 kann beispielsweise in einer vorbestimmten Höhe, beispielsweise in 6 m Höhe, auf einem isolierten Träger angeordnet und mit den Leitungen 2, 3 verbunden sein. Alternativ kann der Leistungsschalter 1 ein geerdetes Gehäuse 8 umfassen, welches isolierte Durchführungen 9 aufweist, durch welche die Leitungen 2, 3 zu dem Schaltkontakt 5 geleitet werden.

Die Messvorrichtung 10 umfasst ein Gehäuse 11, in welchem eine Stromerzeugungseinheit 12, eine Messeinheit 13, die Steuereinheit 14 und die Energieversorgungseinheit 15 angeordnet sind. Die Stromerzeugungseinheit 12 ist zur Erzeugung eines Messstroms für eine Durchgangsmessung des Schaltkontakts 5 des Leistungsschalters 1 ausgestaltet und in der Lage, einen Messstrom von vorzugsweise hundert Ampere oder mehr bereitzustellen. Um einen Messstrom mit hoher Energie kurzzeitig bereitstellen zu können, kann die Messvorrichtung 10 ferner einen kapazitiven Energiespeicher 21 umfassen, welcher mit der Stromerzeugungseinheit 12 gekoppelt ist, um der Stromerzeugungseinheit 12 kurzfristig mehr Energie bereitzustellen, als über einen Energieversorgungsanschluss 20 der Messvorrichtung 10 verfügbar ist. Die Stromerzeugungseinheit 12 ist über Verbindungen 32, 33 mit dem Leistungsschalter 1 derart gekoppelt, dass ein Messstrom von der Stromerzeugungseinheit 12 über den Schaltkontakt 5 des Leistungsschalters 1 geführt werden kann. Die Messeinheit 13 ist über Verbindungen 34, 35 mit dem Leistungsschalter 1 derart gekoppelt, dass die Messeinheit 13 ein Messsignal an dem Leistungsschalter 1 erfassen kann, beispielsweise einen Spannungsabfall über dem Schaltkontakt 5.

Die Steuereinheit 14 ist mit der Stromerzeugungseinheit 12, der Messeinheit 13 und über einen Steuerausgang 19 und die Verbindung 31 mit dem Leistungsschalter 1 verbunden. Weiterhin umfasst die Steuereinheit 14 einen Zeitgeber 18, um Vorgänge zeitlich genau steuern und aufzeichnen zu können. Somit ist die Steuereinheit 14 zur Durchführung eines so genannten Timing-Tests und einer so genannten dynamischen Widerstandsmessung des Leistungsschalters 1 geeignet. Dabei steuert die Steuereinheit 14 den Leistungsschalter an, um den Schaltkontakt 5 zu öffnen oder zu schießen. Mittels der Signale von der Messeinheit 13 bestimmt die Steuereinheit 14 das zeitliche Schaltverhalten des Leistungsschalters 1, beispielsweise eine Zeitdauer zwischen einem Ausgeben eines Befehls zum Öffnen des Schaltkontakts 5 und dem Zeitpunkt, zu welchem die Verbindung über den Schaltkontakt 5 tatsächlich unterbrochen wird. Zusätzlich kann die Steuereinheit 14 Signale von Hilfskontakten des Leistungsschalters 1 über beispielsweise die Verbindung 31 empfangen, um zusätzliche Informationen über den zeitlichen Verlauf des Schaltverhaltens des Leistungsschalters 1 zu bestimmen und zu protokollieren. Die von der Steuereinheit 14 bestimmten Informationen bezüglich des Schaltverhaltens des Leistungsschalters 1 können beispielsweise an die Auswertevorrichtung 40 übertragen werden. Die Übertragung kann beispielsweise über ein spezielles Datenübertragungskabel in digitaler Form erfolgen oder beispielsweise als digitale Daten über ein Energieversorgungskabel 36, welches die Messvorrichtung 10 mit einem Energieversorgungsnetz 37 koppelt, mit welchem auch die Auswertevorrichtung 40 gekoppelt ist. Verfahren zum Übertragen digitaler Informationen über Energieversorgungsleitungen sind in dem Stand der Technik beispielsweise unter dem Schlagwort Power over Ethernet oder Power Line Communication bekannt.

Wenn der Leistungsschalter 1 wie zuvor beschrieben in einem geerdeten Gehäuse 8 angeordnet ist, wobei die Hochspannungsleitungen 2, 3 über Durchführungen 9 in das Innere des geerdeten Gehäuses 8 geführt werden, kann mit der Messvorrichtung 10 und einer Verlustfaktormesseinrichtung 16 und einer Hochspannungserzeugungseinheit 17 eine Verlustfaktormessung durchgeführt werden, um den Zustand der Durchführungen 9 zu beurteilen. Dazu wird in der Energieversorgungseinheit 15 eine Spannung erzeugt und mittels der Hochspannungserzeugungseinheit 17 in eine Hochspannung von mehreren Kilovolt umgewandelt, beispielsweise im Bereich von 2-12 kV, und über eine Verbindung 38 zur Durchführung 9 geführt. Mit beispielsweise einer Verlustfaktormessbrücke in der Verlustfaktormessvorrichtung 16 kann mittels der Leitung 39 an einem Testanschluss der Durchführung 9 überprüft werden, wie nahe die Kapazität der kapazitiven Durchführung 9 an eine ideale Kapazität herankommt, um daraus den Zustand der Durchführung 9 bestimmen zu können.

Wenn der Schaltkontakt 5 des Leistungsschalters 1 geschlossen ist, kann der Widerstand des Schaltkontakts in Abhängigkeit von dem von der Stromerzeugungseinheit 12 bereitgestellten Messstrom und dem von der Messeinheit 13 bestimmten Spannungsabfall über dem Schaltkontakt 5 bestimmt werden dies ist die so genannte Mikroohmmessung. Somit kann beispielsweise ein Verschleißzustand des Schaltkontakts 5 und eine Funktionsfähigkeit des Leistungsschalters 1 mit der Messvorrichtung 10 ohne zusätzliche Neuverkabelung in einem Schritt durchgeführt werden.

Zusammenfassend ist mit der Messvorrichtung 10 ein umfangreicher Test des Leistungsschalters 1 möglich, welcher insbesondere einen Timing-Test, einen Mikroohm-Test und einen Verlustfaktortest umfasst. Da die Messvorrichtung 10 alle für den Test und die Ansteuerung des Leistungsschalters 1 erforderlichen Signale, insbesondere den Messstrom, Steuersignale, Versorgungsspannungen und die Hochspannung, bereitstellt, sind keine zusätzlichen Komponenten für die Überprüfung des Leistungsschalters 1 erforderlich.

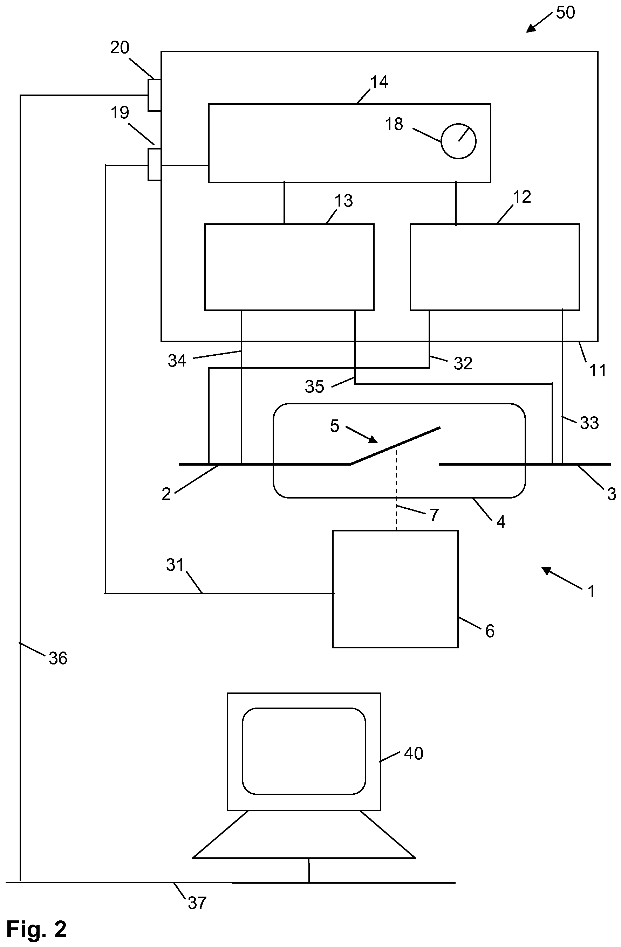

Fig. 2 zeigt eine Messvorrichtung 50, welche die zuvor beschriebene Stromerzeugungseinheit 12, die Messeinheit 13, den Steuerausgang 19 und die Steuereinheit 14 mit dem Zeitgeber 18 umfasst. Die Stromerzeugungseinheit 12 und die Messeinheit 13 entsprechen den entsprechenden Komponenten der Fig. 1 und werden daher hier nicht noch einmal im Detail beschrieben werden. Die Steuereinheit 14 ist in der Lage, über den Steuerausgang 19 ein Signal zum Öffnen oder Schließen des Leistungsschalters 1 auszugeben und ein zeitliches Schaltverhalten des Leistungsschalters in Abhängigkeit von dem Messsignal der Messvorrichtung 13 zu bestimmen. Das Signal, welches die Steuereinheit über den Steuerausgang 19 zum Öffnen oder Schließen des Leistungsschalters ausgibt, ist eine Steuernachricht gemäß der Norm IEC 61850. Die Steuereinheit kann ferner in der Lage sein, ein Signal von einem Hilfskontakt des Leistungsschalters 1 zu empfangen, welches einen Fortschritt des Öffnens oder Schließens des Leistungsschalters 1 anzeigt und ebenfalls mittels einer Nachricht gemäß der Norm IEC 61850 von dem Leistungsschalter 1 zu der Steuereinheit 14 übertragen wird. Indem die Messvorrichtung 50 direkt zum Senden und Empfangen von Kommandos und Nachrichten gemäß der Norm IEC 61850 geeignet ist, können Leistungsschalter, welche gemäß der Norm IEC 61850 gesteuert werden, ohne zusätzliche Komponenten direkt von der Messvorrichtung 50 angesteuert und überprüft werden.

## Patentansprüche

1. Messvorrichtung zum Überprüfen eines elektrischen Leistungsschalters, umfassend:
- eine Stromerzeugungseinheit (12), welche zur Erzeugung eines Messstrom für eine Durchgangsmessung eines Schaltkontakts (5) des Leistungsschalters (1) ausgestaltet ist und zur Einspeisung des Messstroms in den Leistungsschalter (1) mit dem Leistungsschalter (1) koppelbar ist, und
- eine Messeinheit (13), welche mit dem Leistungsschalter (1) koppelbar ist und ausgestaltet ist, ein Messsignal an dem Leistungsschalter (1) zu erfassen, **gekennzeichnet durch**:
- einen Steuerausgang (19), welcher mit einem Steuerantrieb (6) des Leistungsschalters (1) koppelbar ist und ausgestaltet ist, Signale zum Öffnen und/oder Schließen des Schaltkontakts (5) des Leistungsschalters (1) auszugeben, und
- eine Steuereinheit (14) mit einem Zeitgeber (18), welche ausgestaltet ist, über den Steuerausgang (19) ein Signal zum Öffnen oder Schließen des Schaltkontakts (5) des Leistungsschalters (1) auszugeben und ein zeitliches Schaltverhalten des Leistungsschalters (1) in Abhängigkeit von dem Messsignal zu bestimmen,
wobei das Signal, welches die Steuereinheit (14) über den Steuerausgang (19) zum Öffnen oder Schließen des Schaltkontakts (5) des Leistungsschalters (1) ausgibt, eine Steuernachricht umfasst.

2. Messvorrichtung nach Anspruch 1, ferner umfassend:
- eine Energieversorgungseinheit (15), welche ausgestaltet ist, den Steuerantrieb (6) zum Öffnen oder Schließen des Leistungsschalters (1) mit elektrischer Energie zu versorgen,
wobei die Steuereinheit (14) ausgestaltet ist, bei geschlossenem Leistungsschalter (1) den Widerstand des Schaltkontakts (5) in Abhängigkeit von dem Messstrom und dem Messsignal zu bestimmen.

3. Messvorrichtung nach Anspruch 2, wobei die Messvorrichtung (10) ein Gehäuse (11) in Form einer tragbaren Einheit umfasst, in welchem zumindest die Stromerzeugungseinheit (12), die Messeinheit (13), die Energieversorgungseinheit (15), der Steuerausgang (19) und die Steuereinheit (14) untergebracht sind.

4. Messvorrichtung nach Anspruch 2 oder 3, wobei der Steuerantrieb (6) einen Energiespeicher zum Betätigen des Schaltkontakts (5) umfasst, wobei die Energieversorgungseinheit (15) ausgestaltet ist, Energie für den Energiespeicher bereitzustellen.

5. Messvorrichtung nach einem der Ansprüche 2-4, ferner umfassend eine von der Energieversorgungseinheit (15) versorgte Hochspannungserzeugungseinheit (17), welche zur Erzeugung einer Hochspannung für eine Verlustfaktormessung eines in einem geerdeten Gehäuse (8) angeordneten Leistungsschalters (1) ausgestaltet ist.

6. Messvorrichtung nach Anspruch 5, ferner umfassend:
- eine Verlustfaktormessvorrichtung (16), welche ausgestaltet ist, einen Verlustfaktor des in dem geerdeten Gehäuse (8) angeordneten Leistungsschalters (1) in Abhängigkeit von der Hochspannung zu bestimmen.

7. Messvorrichtung nach Anspruch 6, wobei die Messvorrichtung (10) ein Gehäuse (11) in Form einer tragbaren Einheit, in welchem zumindest die Stromerzeugungseinheit (12), die Messeinheit (13), die Energieversorgungseinheit (15), der Steuerausgang (19) und die Steuereinheit (14) untergebracht sind, und eine Hochspannungserzeugungseinheit (17), welche von der Energieversorgungseinheit (15) versorgt wird, und eine Verlustfaktormesseinrichtung (16) umfasst.

8. Messvorrichtung nach einem der vorhergehenden Ansprüche, wobei der Steuerantrieb (6) des Leistungsschalters (1) Auslösevorrichtungen umfasst, welchen Signale zum Öffnen und/oder Schließen des Leistungsschalters zuführbar sind, wobei die Messvorrichtung (10) ausgestaltet ist, eine elektrische Leistung zum Ansteuern der Auslösevorrichtungen über den Steuerausgang (19) bereitzustellen.

9. Messvorrichtung nach einem der vorhergehenden Ansprüche, wobei die Messeinheit (13) ausgestaltet ist, einen Messsignalverlauf zu erfassen, und die Steuereinheit (14) ausgestaltet ist, einen Widerstandsverlauf des Schaltkontakts (5) in Abhängigkeit von dem Messstrom und dem Messsignalverlauf zu bestimmen.

10. Messvorrichtung nach einem der vorhergehenden Ansprüche, wobei die Stromerzeugungseinheit (12) zur Erzeugung eines Messstroms von mindestens 100A ausgestaltet ist.

11. Messvorrichtung nach einem der vorhergehenden Ansprüche, wobei das Messsignal eine Spannung über dem Schaltkontakt (5) des Leistungsschalters (1) umfasst.

12. Messvorrichtung nach einem der vorhergehenden Ansprüche, wobei die Steuereinheit (14) ausgestaltet ist,
ein Signal von einem Hilfskontakt des Leistungsschalters (1) zu empfangen, welches einen Fortschritt des Öffnens und/oder Schließens des Leistungsschalters (1) anzeigt, und
das zeitliches Schaltverhalten des Leistungsschalters (1) in Abhängigkeit von dem Messsignal und dem Signal von dem Hilfskontakt zu bestimmen.

13. Messvorrichtung nach Anspruch 12, wobei die Steuereinheit (14) ausgestaltet ist, das Signal von dem Hilfskontakt des Leistungsschalters (1) mittel einer Nachricht zu empfangen.

## Claims

1. Measuring device for checking an electrical circuit breaker, comprising:
- a current generating unit (12), which is designed to generate a measurement current for a continuity measurement of a switching contact (5) of the circuit breaker (1) and which can be coupled to the circuit breaker (1) for the purpose of feeding the measurement current into the circuit breaker (1),
- a measuring unit (13), which can be coupled to the circuit breaker (1) and which is designed to detect a measurement signal at the circuit breaker (1),
**characterized by**
- a control output (19), which can be coupled to a control drive (6) of the circuit breaker (1) and which is designed to output signals for opening and/or closing the switching contact (5) of the circuit breaker (1), and
- a control unit (14) having a timer (18), which is designed to output, via the control output (19), a signal for opening or closing the circuit breaker (1), and to determine a time-based switching behaviour of the circuit breaker (1) in dependence on the measurement signal, wherein the signal that is output by the control unit (14) via the control output (19) for opening or closing the switching contact (5) of the circuit breaker (1) comprises a control message.

2. Measuring device according to claim 1, further comprising:
- an energy supply unit (15), which is designed to supply the control drive (6) with electrical energy for opening or closing the circuit breaker (1),
wherein the control unit (14) is designed to determine the resistance of the switching contact (5) in dependence on the measurement current and the measurement signal when the circuit breaker (1) is closed.

3. Measuring device according to claim 2, wherein the measuring device (10) comprises a housing (11) in the form of a portable unit, in which at least the current generating unit (12), the measuring unit (13), the energy supply unit (15), the control output (19) and the control unit (14) are accommodated.

4. Measuring device according to claim 2 or claim 3, wherein the control drive (6) comprises an energy storage for actuating the switching contact (5), the energy supply unit (15) being designed to provide energy for the energy storage.

5. Measuring device according to any one of claims 2-4, further comprising a high-voltage generating unit (17), which is supplied by the energy supply unit (15) and which is designed to generate a high voltage for a loss-factor measurement of a circuit breaker (1) disposed in an earthed housing (8).

6. Measuring device according to claim 5, further comprising:
- a loss-factor measuring device (16), which is designed to determine a loss factor of the circuit breaker (1), disposed in an earthed housing (8), in dependence on the high voltage.

7. Measuring device according to claim 6, wherein the measuring device (10) comprises a housing (11) in the form of a portable unit, in which at least the current generating unit (12), the measuring unit (13), the energy supply unit (15), the control output (19) and the control unit (14) are accommodated, and which comprises a high-voltage generating unit (17), which is supplied by the energy supply unit (15), and a loss-factor measuring device (16).

8. Measuring device according to any one of the preceding claims, wherein the control drive (6) of the circuit breaker (1) comprises trip devices, to which signals for opening and/or closing the circuit breaker can be supplied, the measuring device (10) being designed to provide an electrical power for activating the trip devices via the control output (19).

9. Measuring device according to any one of the preceding claims, wherein the measuring unit (13) is designed to detect a measurement signal course, and the control unit (14) is designed to determine a resistance course of the switching contact (5) in dependence on the measurement current and the measurement signal course.

10. Measuring device according to any one of the preceding claims, wherein the current generating unit (12) is designed to generate a measurement current of at least 100 A.

11. Measuring device according to any one of the preceding claims, wherein the measurement signal comprises a voltage across the switching contact (5) of the circuit breaker (1).

12. Measuring device according to any one of the preceding claims, wherein the control unit (14) is designed
to receive a signal from an auxiliary contact of the circuit breaker (1), which signal indicates a progress of the opening or closing of the circuit breaker (1), and
to determine the time-based switching behaviour of the circuit breaker (1) in dependence on the measurement signal and the signal from the auxiliary contact.

13. Measuring device according to claim 12, wherein the control unit (14) is designed to receive the signal from the auxiliary contact of the circuit breaker (1) by means of a message.

## Revendications

1. Dispositif de mesure destiné à contrôler un disjoncteur électrique, comprenant :
- une unité de génération de courant (12) qui est configurée pour la génération d'un courant de mesure pour une mesure de passage d'un contact de commutation (5) du disjoncteur (1) et peut être couplée avec le disjoncteur (1) pour l'injection du courant de mesure dans le disjoncteur (1), et
- une unité de mesure (13) qui peut être couplée au disjoncteur (1) et est configurée afin de détecter un signal de mesure sur le disjoncteur (1),
**caractérisé par** :
- une sortie de commande (19) qui peut être couplée à un entraînement de commande (6) du disjoncteur (1) et est configurée afin d'émettre des signaux d'ouverture et/ou de fermeture du contact de commutation (5) du disjoncteur (1), et
- une unité de commande (14) avec une horloge (18) qui est configurée afin d'émettre par le biais de la sortie de commande (19) un signal d'ouverture ou de fermeture du contact de commutation (5) du disjoncteur (1) et de déterminer un comportement de commutation temporel du disjoncteur (1) en fonction du signal de mesure,
dans lequel le signal qu'émet l'unité de commande (14) par le biais de la sortie de commande (19) pour l'ouverture ou la fermeture du contact de commutation (5) du disjoncteur (1) comporte un message de commande.

2. Dispositif de mesure selon la revendication 1, comprenant en outre :
- une unité d'alimentation en énergie (15) qui est configurée afin d'alimenter en énergie électrique l'entraînement de commande (6) pour l'ouverture ou la fermeture du disjoncteur (1),
dans lequel l'unité de commande (14) est configurée afin de déterminer en cas de disjoncteur fermé (1) la résistance du contact de commutation (5) en fonction du courant de mesure et du signal de mesure.

3. Dispositif de mesure selon la revendication 2, dans lequel le dispositif de mesure (10) comporte un boîtier (11) sous la forme d'une unité portable, dans lequel au moins l'unité de génération de courant (12), l'unité de mesure (13), l'unité d'alimentation en énergie (15), la sortie de commande (19) et l'unité de commande (14) sont logées.

4. Dispositif de mesure selon la revendication 2 ou 3, dans lequel l'entraînement de commande (6) comporte un accumulateur d'énergie pour l'actionnement du contact de commutation (5), dans lequel l'unité d'alimentation en énergie (15) est configurée afin de mettre à disposition de l'énergie pour l'accumulateur d'énergie.

5. Dispositif de mesure selon l'une quelconque des revendications 2 à 4, comprenant en outre une unité de génération de haute tension (17) qui est alimentée par l'unité d'alimentation en énergie (15) et qui est configurée pour la génération d'une haute tension pour une mesure de facteur de perte d'un disjoncteur (1) agencé dans un boîtier (8) mis à la terre.

6. Dispositif de mesure selon la revendication 5, comprenant en outre :
- un dispositif de mesure de facteur de perte (16) qui est configuré afin de déterminer un facteur de perte du disjoncteur (1) agencé dans le boîtier (8) mis à la terre en fonction de la haute tension.

7. Dispositif de mesure selon la revendication 6, dans lequel le dispositif de mesure (10) comporte un boîtier (11) sous la forme d'une unité portable dans laquelle au moins l'unité de génération de courant (12), l'unité de mesure (13), l'unité d'alimentation en énergie (15), la sortie de commande (19) et l'unité de commande (14) sont logées, et une unité de génération de haute tension (17) qui est alimentée par l'unité d'alimentation en énergie (15), et un dispositif de mesure de facteur de perte (16).

8. Dispositif de mesure selon l'une quelconque des revendications précédentes, dans lequel l'entraînement de commande (6) du disjoncteur (1) comporte des dispositifs de déclenchement auxquels des signaux peuvent être fournis pour ouvrir et/ou fermer le disjoncteur, dans lequel le dispositif de mesure (10) est configuré afin de mettre à disposition une puissance électrique pour la commande des dispositifs de déclenchement par le biais de la sortie de commande (19).

9. Dispositif de mesure selon l'une quelconque des revendications précédentes, dans lequel l'unité de mesure (13) est configurée afin de détecter une courbe de signal de mesure, et l'unité de commande (14) est configurée afin de déterminer une courbe de résistance du contact de commutation (5) en fonction du courant de mesure et de la courbe de signal de mesure.

10. Dispositif de mesure selon l'une quelconque des revendications précédentes, dans lequel l'unité de génération de courant (12) est configurée pour la génération d'un courant de mesure d'au moins 100 A.

11. Dispositif de mesure selon l'une quelconque des revendications précédentes, dans lequel le signal de mesure comporte une tension au contact de commutation (5) du disjoncteur (1).

12. Dispositif de mesure selon l'une quelconque des revendications précédentes, dans lequel l'unité de commande (14) est configurée
afin de recevoir un signal d'un contact auxiliaire du disjoncteur (1), qui affiche une progression de l'ouverture et/ou de la fermeture du disjoncteur (1), et
afin de déterminer le comportement de commutation temporel du disjoncteur (1) en fonction du signal de mesure et du signal du contact auxiliaire.

13. Dispositif de mesure selon la revendication 12, dans lequel l'unité de commande (14) est configurée afin de recevoir le signal du contact auxiliaire du disjoncteur (1) au moyen d'un message.
